# EUROPÄISCHE PATENTSCHRIFT

(11) **EP 0 514 630 B1**
(45) Veröffentlichungstag und Bekanntmachung des Hinweises auf die Patenterteilung: **30.07.1997**
(21) Anmeldenummer: 92103439.3
(22) Anmeldetag: 28.02.1992
(51) Int. Cl.: C09D 163/10, G03F 7/038, C08F 299/02, C08F 299/06, B23K 35/22, C08L 63/10

(54) **Durch Strahlung vernetzbare Beschichtungsmittel und ihre Verwendung**
Radiation crosslinkable coating and its use
Revêtement durcissable par exposition aux rayonnements et son utilisation

(30) Priorität: 24.05.1991 DE 4116957
(43) Veröffentlichungstag der Anmeldung: 25.11.1992
(73) Patentinhaber: Bakelite AG, 58642 Iserlohn-Letmathe (DE); Lackwerke Peters GmbH + Co KG, 47906 Kempen (DE)
(72) Erfinder: Grundke, Ulrich, W-4100 Duisburg 12 (DE); Liebetanz, Klaus-Peter, W-4100 Duisburg 12 (DE); Hansen, Achim, Dr., W-5860 Iserlohn 7 (DE); Zehrfeld, Jürgen, Dr., W-4223 Voerde (DE); Scharre, Rainer, W-4152 Kempen 1 (DE); Peters, Werner, W-4152 Kempen 1 (DE)

(56) Entgegenhaltungen:
- EP-A- 0 194 360
- EP-A- 0 471 151
- US-A- 4 618 658
- WORLD PATENTS INDEX LATEST Derwent Publications Ltd., London, GB; AN 90-071413

## Beschreibung

Die Erfindung betrifft neue Beschichtungmittel zur Herstellung von Schutzüberzügen, die durch Strahlung vernetzbar sind.

An diese Beschichtungsmittel oder Lacke werden, insbesondere bei ihrer Verwendung in der Elektronik, hohe Anforderungen gestellt, die durch Auswahl der geeigneten Bindemittel und Zusatzstoffe sowie durch deren Rezeptierung im Beschichtungsmittelgemisch zu erfüllen sind.

Aus EP-A 0 075 537 sind Beschichtungsmittel bekannt, die als Bindemittel ein lichtempfindliches und thermisch härtbares Epoxidharz, einen Härter, Lösemittel und, bezogen auf die lichempfindliche Substanz, 10 bis 50 Gew.-% eines feinteiligen Füllstoffes enthalten.

Diese Beschichtungsmittel sind geeignet für eine gleichmäßige Beschichtung von Leiterplatten nach dem Vorhanggießverfahren. Sie haben eine gegenüber dem vorbekannten Stand der Technik verbesserte Kantendeckung, Haftung und Lötbadbeständigkeit.

In der praktischen Anwendung der Beschichtung von Leiterplatten zeigen sich allerdings noch Mängel, die nur durch grundlegend andere Beschichtungsmittel behebbar sind:

Die gewünschte gute Kantendeckung ist nur durch Einsatz hochmolekularer Harze möglich. Daraus ergibt sich normalerweise eine geringere Auflösung, die aber bei feinen Strukturen unabdinglich ist, eine schwierigere Entwickelbarkeit und eine erhöhte Sprödigkeit der belichteten Lackschichten. Nach der Belichtung bei der Entnahme der Platten aus den Zentrierstiften enstehende Lacksplitter führen bei nachfolgenden Leiterplatten zu Fehlern. Da diese Lacksplitter für das UV-Licht bei der Belichtung undurchlässig sind, wird an diesen Stellen der Lackfilm nicht vorpolymerisiert und während der Entwicklung abgelöst; es entstehen sogenannte pin-holes.

Eine Mehrfachbeschichtung, um eine gute Kantendeckung zu erzielen, ist nicht möglich, da die licht- und thermisch härtbaren Polymere bei einem mehrfachen Trocknungsprozeß zu stark polymerisieren und somit eine nachträgliche Entwicklung nicht mehr möglich ist, bzw. durch die nur oberflächlich stattfindende Strahlungshärtung ein zu starkes Undercutting im Entwicklungsprozeß resultiert.

Es ist daher Aufgabe der Erfindung, ein durch Strahlung vernetzbares Beschichtungsmittel bereitzustellen, das neben guter Haftung auch auf Blei-/Zinn-Legierungen und guter Lötbadbeständigkeit eine sehr gute Kantenabdeckung ermöglicht, das aber zudem eine hohe Auflösung auch bei feinen Strukturen ergibt, das nach Belichtung leicht entwickelbar ist, keinen sogenannten Undercut zeigt und nicht spröde ist.

Die Lösung der Aufgabe erfolgt durch Beschichtungsmittel gemäß der Ansprüche 1 bis 9.

Sie finden gemäß der Ansprüche 10 bis 14 Anwendung zur Herstellung von Beschichtungen für die Elektronik und Elektrotechnik, insbesondere als Lötstopplack sowie zur Herstellung von Schutzmasken, insbesondere solchen, die nach dem Vorhanggießverfahren hergestellt werden, sowie von Lötstopmasken, die im Siebdruck, Roller-coating-Verfahren, Tampondruck oder Aufschleuderverfahren oder die durch konventionelles oder elektrostatisches Spritzen oder durch Kombination dieser Verfahren hergestellt werden.

Es wurde gefunden, daß Beschichtungsmittel die als Bindemittelkomponenten einen olefinisch ungesättigten Ester eines Epoxidnovolakharzes und ein Bindemittel enthalten, das erhalten wird durch Umsetzung einer Epoxidverbindung mit mehr als 1 Epoxidgruppe pro Molekül, mit einer oder mehreren Carbonsäuren im molaren Verhältnis der Epoxidgruppen zu den Carboxylgruppen von 1 : 0,5 bis 0,9 und anschließender Umsetzung des Reaktionsproduktes mit einer oder mehreren ungesättigten Isocyanatocarbamatestern, die durch Umsetzung von Verbindungen mit mindestens zwei Isocyanatgruppen mit hydroxylgruppenhaltigen Acryl-, Methacryl- oder Cyanacrylsäureestern hergestellt werden, die geforderten Eigenschaften erfüllen. Durch die Abmischung der beiden Komponenten werden Systeme erhalten, die in ihren Eigenschaften anders sind als entsprechende Systeme mit nur einer Bindemittelkomponente mit entsprechendem Verhältnis an olefinisch ungesättigten und Epoxid-Gruppen.

Die erfindungsgemäß hergestellten Beschichtungsmittel sind durch Strahlung vernetzbar. Sie haben eine gute Lötbadbeständigkeit, haften gut auf allen in der Leiterplattenindustrie üblichen Untergründen, insbesondere auf Kupfer, Blei/Zinn sowie auf epoxid- und phenolharzgebundenen Leiterplatten. Auch bei feinen Strukturen läßt sich eine hohe Auflösung erzielen. Die entsprechenden Lackschichten sind nach der Belichtung leicht und vor allem mit umweltfreundlichen Lösemitteln oder mit alkalischen wäßrigen Lösungen zu entwickeln. Es entsteht dabei kein Undercut, d. h., feine Stege bleiben nach der Entwicklung darstellbar. Vor allem aber ist der gehärtete Lackfilm nicht spröde, sondern hat mehr oder minder plastische bzw. thermoplastische Anteile. Der Lack bricht nicht ab. Die Gefahr von Fehlern durch Lacksplitter (pin-holes) ist nicht gegeben.

Eine Mehrfachbeschichtung ohne Belichtung, Entwicklung und Endaushärtung der Einzelschichten ist mit dem erfindungsgemäßen Beschichtungsmittel möglich.

Vor allem aber erlaubt es die erfindungsgemäße Bindemittelkombination, daß die entsprechenden Beschichtungsmittel auch ohne Lösemittel einen hohen Anteil an feinteiligen Füllstoffen enthalten können. Bevorzugt sind Füllstoffgehalte von 80 bis 120 Gew.-%, bezogen auf das Bindemittelgemisch.

Überraschenderweise lassen sich trotz dieses hohen Füllstoffanteils Beschichtungsmittel mit relativ niedriger Viskosität und gutem Fließverhalten herstellen. Die entsprechenden Beschichtungsmittel eignen sich gut für das Vorhanggießverfahren, verlaufen gut und trotz hohem Festkörpergehalt blasenfrei auch bei hohen Schichtdicken.

Dabei wird eine hervorragende Kantenabdeckung mit nahezu senkrecht entwickelbaren Lackkanten erzielt.

Weitere, durch den hohen Füllstoffgehalt erzielte Vorteile sind ein geringer Volumenschwund, somit die zu erzielende hohe Trockenschichtdicke, bessere Kantenabdeckung sowie das zuverlässige und selbständige Verschließen von Durchsteigerbohrungen durch die aufgebrachte Beschichtung.

Die beiden erfindungsgemäß eingesetzten Bindemittelkomponenten sind an sich bekannt:

Olefinisch ungesättigte Ester eines Epoxynovolakharzes sind einfache Umsetzungsprodukte von olefinisch ungesättigten Carbonsäuren mit Novolaken, deren phenolische Hydroxylgruppen mit Glycidylresten veräthert sind. Bespiele für olefinisch ungesättigte Carbonsäuren sind Acryl-, Methacryl-, halogenierte Acryl- oder Methacrylsäure, Zimtsäure oder Hydroxyalkylacrylat- oder -methacrylathalbester von Dicarbonsäuren, wobei die Hydroxyalkylgruppe vorzugsweise 2 bis 6 Kohlenstoffatome aufweist. Die Säure wird im allgemeinen mit dem Polyepoxid in einem Verhältnis von 1 Äquivalent Säure pro Äquivalent Epoxid umgesetzt. Jedoch können die entsprechenden äquivalenten Verhältnisse im Bereich von 0,8 : 1 bis 1,2 : 1 variiert werden.

Die Epoxynovolakkomponente entspricht der nachfolgend für die Bindemittelkomponente b beschriebenen. Die Umsetzung der Säuren mit der Epoxykomponente erfolgt mittels üblicher Verfahren wie sie u. a. in EP-A 0 003 040 oder EP-B 0 194 360 beschrieben sind.

Als olefinisch ungesättigte Ester von Epoxynovolaken sind aber auch Produkte aus der Umsetzung eines gesättigten oder ungesättigten polybasischen Säureanhydrids mit einem Reaktionsprodukt aus einer Epoxyverbindung vom Novolaktyp und einer ungesättigten Monocarbonsäure anzusehen, wie sie aus DE-A 36 13 107 bekannt sind. Diese Produkte haben bei 25 °C eine Viskosität von 2.000 bis 4.000 mPa·s.

Bindemittel der Komponente B sind aus EP-B 0 194 360 bekannt.

Gemäß dieser Schrift werden sie hergestellt durch Umsetzung einer Epoxidverbindung mit mehr als 1 Epoxidgruppe pro Molekül mit einer oder mehreren Carbonsäuren im molaren Verhältnis der Epoxidgruppen zu den Caboxylgruppen von 1 : 0,5 bis 0,9 und anschließender Umsetzung des Reaktionsproduktes mit einer oder mehreren ungesättigten Isocyanatocarbamatestern, die durch Umsetzung von Verbindungen mit mindestens zwei Isocyanatgruppen mit hydroxylgruppenhaltigen Acryl-, Methacryl oder Cyanacrylsäureestern hergestellt werden.

Als Ausgangs-Epoxidharze für diese Bindemittel eignen sich prinzipiell alle Verbindungen, die mehr als 1 Epoxidgruppe pro Molekül enthalten. Sie werden erhalten entweder durch Umsetzung von Polyphenolen bzw. Polyalkoholen mit Epichlorhydrin oder durch Umsetzung von mehrfach ungesättigten Verbindungen mit organischen Persäuren.

Vorteilhaft sind die Umsetzungsprodukte von Bisphenol A mit Epichlorhydrin in alkalischem Medium sowie die Polyglycidylether von Resorcin, Butandiol, Hexandiol, Glycerin, Trimethylolpropan und Neopentylglykol. Bevorzugte Vertreter der durch Persäuren epoxidierten mehrfach ungesättigten Verbindungen sind epoxidierte Cycloolefine wie z. B. 3,4-Diepoxi-6-methyl-tetrahydro-benzyl-3',4'-diepoxi-6-methyl-tetrahydro-benzoat, Vinylcyclohexendioxid u. a. sowie die Diglycidylester auf Basis von Anhydriden, wie Hexahydrophthalsäure- oder Methylnadicsäure-anhydrid.

Insbesondere bevorzugt sind alle Novolake, deren phenolische Hydroxylgruppen mit Glycidylresten verethert sind, z. B. Bisphenol-A- oder Bisphenol-F-Novolak-Epoxidharze oder die entsprechenden Ortho- oder Para-Kresol-Epoxidharz-Novolaksysteme bzw. entsprechende chlorierte oder bromierte Produkte für schwer entflammbare Einstellungen. Die hierfür erforderlichen Novolake können hergestellt werden z. B. auf Basis von Phenol, ortho-, meta- oder para-Kresol, Dimethylphenolen, höheralkylierten Phenolen, z. B. Nonylphenol, tert.-Butylphenol, oder halogenierten Phenolen sowie Polyphenolen, z. B. Resorcin, Hydrochinon, Brenzkatechin, Pyrogallol, Phloroglucin oder auch Trihydroxyphenylmethan oder Tetrahydroxyphenylethan durch Umsetzung mit Aldehyden, vorzugsweise Formaldehyd unter saurer Katalyse.

Diesen Epoxidharzen können vor der Umsetzung zum Zwecke einer besseren Viskositätseinstellung vor der Umsetzung mit Carbonsäuren Zusätze von mono- und bifunktionellen Epoxidverbindungen sog. Reaktivverdünnern, zugegeben werden.

Als Carbonsäuren können alle gängigen Monocarbonsäuren verwendet werden. Beispiele hierfür sind die unverzweigten Monocarbonsäuren, wie die Ameisensäure, Essigsäure, Propionsäure, Milchsäure, Stearinsäure sowie auch verzweigte Carbonsäuren wie Benzoesäure oder Zimtsäure sowie die Phenylessigsäure und bevorzugt ungesättigte Carbonsäuren vom Typ der Acrylsäure und Methacrylsäure.

Die Umsetzung erfolgt in an sich bekannter Weise durch Zusammenrühren der flüssigen oder in Lösung vorliegenden Reaktanden bei erhöhter Temperatur. Wichtig für die Eigenschaften des Endproduktes ist das molare Verhältnis der Epoxidgruppen zu den Carboxylgruppen, das in jedem Falle größer als 1 sein muß, daß freie Epoxidgruppen vorliegen, die nach der strahlungsbedingten Vernetzung eine thermische Härtung ermöglichen. Im allgemeinen liegt das Verhältnis zwischen 1 : 0,5 bis 0,9.

Die Umsetzung der vorgenannten Epoxidharzsysteme mit den Monocarbonsäuren führt zu Umsetzungsprodukten, die sich in hervorragender Weise für eine weitere Umsetzung mit ungesättigten Isocyanatocarbamatestern eignen. Die Isocyanatocarbamatester können hergestellt werden durch Umsetzung von Polyisocyanaten, z. B. 2,4- oder 2,6-Toluylendiisocyanaten bzw. auch deren Isomeren-Mischungen (Handelsbezeichnung z. B. "Desmodur ® T 80"), Methylendiphenyldiisocyanat, 1,6-Hexamethylendiisocyanat, Hexandiisocyanat, 1,5-Naphthylendiisocyanat, Isophorondiisocyanat, Trimethylhexamethylendiisocyanat, 4,4', 4''-Triphenylmethan-Triisocyanat oder anderen bekannten Polyisocyanaten mit hydroxylgruppenhaltigen Estern.

Als hydroxylgruppenhaltige ungesättigte Ester eignen sich insbesondere Hydroxyl-ethyl oder-propylacrylat oder die entsprechenden Hydroxy-methacrylate oder Hydroxy-cyanacrylate, auch Butan- oder Hexandiolmonoacrylate.

Umgesetzt wird in an sich bekannter Weise im einrach molaren Verhältnis. Die ungesättigten Isocyanatocarbamatester entsprechen der allgemeinen Formel 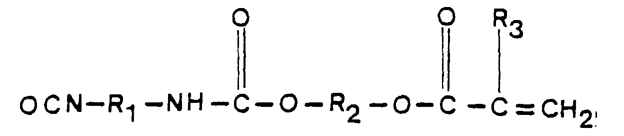 wobei
- R₁ =: Toluylen(2,4; 2,6)-, R₂ = C₂H₄-, C₃H₆-, 4,4'-Diphenylmethan-, C₄H₈-,
1,6-Hexamethylen-,
1,5-naphthylen-, R₃ = H-, CH₃-, CN-,
Isophoron- C₂H₅-,
Trimethylhexamethylen C₃H₇- ist.

Zur Herstellung der erfindungsgemäßen Beschichtungsmittel werden die Bindemittelkomponenten A und B im Gewichtsverhältnis von 80 : 20 bis 20 : 80 miteinander und mit einem oder mehreren latenten Härtern und gegebenenfalls mit weiteren Füll-, Zusatz- und Hilfsstoffen sowie Lösemitteln vermischt.

Zur gezielten Einstellung der UV-Reaktivität können die allgemein üblichen Photoinitiatoren, wie z. B. Benzoine, oder Benzildimethylketal, Benzoinether, Benzophenone, Dithio-bis(benzothialzol), Oxophosphorane und Kombinationen von aromatischen Sulfochloriden mit Disulfiden oder Xanthogenaten, zur Erhöhung der Polymerisationsgeschwindigkeit eingesetzt werden. Belichtungszeiten von unter 30 s sind problemlos einstellbar, wobei klebfreie Filme erreicht werden, die nach der thermischen Härtung hohe mechanische, thermische und elektrische Eigenschaftniveaus und gute Chemikalienbeständigkeiten zeigen.

Die strahlungsvernetzbaren Bindemittelsysteme werden vorzugsweise durch Zusatz von Katalysatoren für die thermische Nachhärtung zur Herstellung von I- oder II-Komponenten-Beschichtungssystemen weiter formuliert. Als latente Katalysatoren für die thermische Nachhärtung der Epoxidgruppen eignen sich z. B. Dicyandiamid, entsprechende Derivate oder BF₃- oder auch BCl₃-Aminkomplexe, Säureanhydride oder deren Addukte, Imidazole und phenolische Härter.

Besonders vorteilhaft sind latente Katalysatoren, die sowohl bei der Vernetzung als Photoinitiatoren als auch bei der thermischen Härtung als Härtungskatalysatoren wirken, sind Verbindungen vom Typ der Michler's Ketons, der allgemeinen Formel 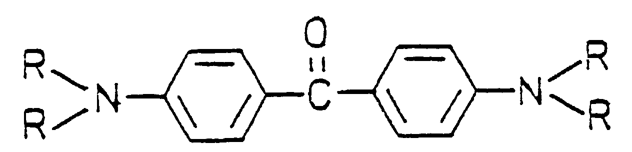 wobei R = CH₃- oder C₂H₅- ist.

Erreicht werden sehr kurze Aushärtungszeiten von 20 - 40 min bei Temperaturen von 120 bis 230 °C, je nachdem, welcher Glasumwandlungspunkt für das Beschichtungssystem erreicht werden soll.

Die resultierenden Beschichtungen sind in gewünschter Weise plastisch verformbar, so daß die Gefahr der Bildung von Lacksplittern bei geringer mechanischer Beanspruchung ausgeschlossen ist.

Die erfindungsgemäßen Beschichtungsmittel sind gegenüber sichtbarem Licht weitgehend unempfindlich. Sie vernetzen lediglich bei Bestrahlung mit UV-Licht oder noch kürzerer, energiereicherer Strahlung. Dies hat den Vorteil, daß ihre Verarbeitung ohne besondere Verdunkelungsmaßnahmen möglich ist.

Zur Herstellung von Photoresists werden Leiterplatten mit dem vorgenannten durch Strahlung härtbaren Beschichtungsmittel im Siebdruck- oder Gieß-Vorhang-Verfahren bzw. den sonstigen beschriebenen Applikationsverfahren unter Verwendung von Lösungsmitteln beschichtet. Nach der Trocknung bzw. Verdunstung des Lösungsmittels wird das Harz anschließend durch eine Negativ- oder Positiv-Maske hindurch einer Strahlung ausgesetzt, wobei die belichteten Stellen durch Polymerisation aushärten und die unpolymerisierten Anteile des Harzes mittels eines Lösungsmittels entfernt werden können. Das Beschichtungsmittel zeichnet sich besonders dadurch aus, daß einerseits sehr feine Strukturen noch mit großer Genauigkeit herstellbar sind, und daß andererseits das Herauslösen der unpolymerisierten Anteile, der sog. Entwicklungsprozeß, mit umweltfreundlichen Lösemitteln wie z. B. Butyldiglykol aber auch mit alkalischen, wäßrigen Lösungen möglich ist.

Die erfindungsgemäßen Beschichtungsmittel können je nach geplantem Anwendungszweck und je nach Art der Formulierung lösemittelfrei eingesetzt werden oder aber auch übliche Lösemittel enthalten.

Geeignete Lösungsmittel, die alleine oder in Gemischen eingesetzt werden können, sind z. B.: Ketone, wie Dimethylketon, Diethylketon, Methylisobutylketon, Cyclohexanon, Cyclopentanon, Cycloheptanon, Isophoron, Methoxyhexanon, Acetonylaceton, Acetonphenon, Benzylethylketon, 3,3,5-Trimethylcyclohexanon, Mesityloxid; halogenierte Kohlenwasserstoffe wie Tetrachlorkohlenstoff, Chloroform, Methylenchlorid, Methylenbromid, Bromchlormethan, 1,2-dichlorethan, 1,1,2-Trichlorethan, 1,1,2,2-Tetrachlorethan, 1,2,3-Trichlorpropan, Perchlorethylen; Alkohole wie Methanol, Ethanol, Propanol, Butanol, Hexanol, Cyclohexanol, Furfurylalkohol, Tetrahydrofurfurylalkohol, Benzylalkohol, monoalkylierte Glykole wie Methylglykol, Ethylglykol, Ethylglykol, Triethylenglykolmonoethyl- oder -monobutylether, Glykole wie Ethylen-, Propylen- oder Butylenglykol und deren Oligomere wie Triethylenglykol; aliphatische und aromatische Kohlenwasserstoffe wie Pentan, Hexan, Cyclohexan, Methylcyclohexan, Benzol, Toluol oder Xylol, Ether wie Diethylether, Dibutylether, Tetrahydrofuran, Dioxan, Ethylenglykoldimethylether, Diethylenglykoldimethylether, Carbonsäureester wie Methyl-, Ethyl-, Propyl-, Butyl- und Isopropyl- sowie Phenylacetat, Propionsäuremethylester, Glykolsäurebutylester, Ethylglykolmono- oder -diacetat, Methyl- oder Ethylglykolsäureacetat; Lactone wie Butyro-Valerolacton; Säureamide wie Dimethylformamid, Dimethylacetamid, Hexamethylphosphorsäuretriamid; Sulfone wie z. B. Dimethylsulfon, Dibutylsulfon oder Tetramethylensulfon.

Die Menge des verwendeten Lösungsmittels richtet sich im wesentlichen nach der gewünschten Viskosität der Beschichtungsmittel, die bei 25 °C bevorzugt zwischen 200 und 800, insbesondere zwischen 200 und 500 mPa s liegt, sowie nach der Menge der eingesetzten Füllstoffe. Sie liegt im allgemeinen im Bereich von 25 bis 40 Gew.-% der im Beschichtungsmittel enthaltenen Bindemittel.

Das erfindungsgemäße Beschichtungsmittel kann auch ohne Lösemittel Füllstoffe enthalten. Mit Lösemitteln kann der Füllstoffanteil 80 bis 120 Gew.-%, bezogen auf das Bindemittelgemisch betragen. Trotz des hohen Füllstoffgehaltes ergibt sich aber noch eine ausreichende Viskosität, die die Anwendung des Beschichtungsmittels im Gießverfahren erlaubt. Trotz des hohen Füllstoffgehaltes ist die durch die Strahlung bedingte Vernetzung weder in ihrer Geschwindigkeit noch in ihrer Dicke der vernetzenden Schicht behindert. Trotz des hohen Füllstoffgehaltes lassen sich auch hohe Schichtdicken blasenfrei auftragen und nach der Belichtung wird eine hohe Auflösung erzielt, so daß auch bei der Anwendung in der Feinstleitertechnik kein sog. Undercutting auftritt.

Andererseits aber werden gerade durch den hohen Füllstoffanteil entscheidende Verbesserungen des Beschichtungsmittels erzielt. Die Auftragung dicker Schichten in einem Gießvorgang ist möglich. Dabei wird eine sehr gute Kantenabdeckung ermöglicht. Die Schrumpfung ist bei der Trocknung der aufgetragenen Beschichtung minimiert. Besonders vorteilhaft aber ist ein selbständiges und zuverlässiges Verschließen von Durchsteigerbohrungen durch die aufgebrachte Beschichtung.

Die eingesetzten Füllstoffe müssen feinteilig sein, d. h., die Partikelgröße des Füllstoffs muß kleiner sein als der Abstand von Leitern in gedruckten Schaltungen. Die mittlere Partikelgröße kann 0,01 bis 10 µm, vorzugsweise 0,01 bis 5 µm betragen. Besonders bevorzugt sind mikronisierte Füllstoffe, die im allgemeinen eine mittlere Partikelgröße von 0,01 bis 1,5 µm aufweisen.

Geeignete Füllstoffe sind beispielsweise kolloidales oder hydrophobiertes Siliziumdioxid, Mikrotalkum, Mikroglimmer, Kaolin, Aluminiumoxide, Magnesiumsilikat, Aluminiumhydroxyd, Calciumsilikat, Aluminiumsilikat, Magnesiumcarbonat, Calciumcarbonat, Zirkoniumsilikat, Porzellanmehl, Antimontrioxid, Titandioxid, Bariumtitanat oder Bariumsulfat oder Gemische der genannten Füllstoffe.

Die Füllstoffe sind vorteilhaft mit einem Haftvermittler versehen, um eine gute Haftung zwischen Polymermatrix und Füllstoff zu erzielen. Übliche Haftvermittler sind z. B. Trialkoxysilane, die funktionelle Gruppen wie z. B. -OH, -NH₂, Epoxid- oder Vinylgruppen enthalten. Beispiele sind Trialkoxysilyl-glycidoxy oder -aminopropan und Trialkoxyvinyl- oder -allylsilan. Die Alkoxygruppe kann 1 bis 12 C-Atome enthalten und z. B. Methyl, Ethyl, Propyl, Butyl, Hexyl, Octyl oder Dodecyl sein.

Die erfindungsgemäßen Beschichtungsmittel können weitere übliche Zusätze enthalten, wie z. B. Haftvermittler, Verlaufmittel, Farbstoffe, Pigmente, Stabilisatoren, Entschäumer, Flammschutzmittel, Photosensibilisatoren und/oder -aktivatoren.

Besonders zweckmäßig ist der Zusatz von Antiabsetzmitteln zur Erhöhung der Lagerstabilität der erfindungsgemäßen Beschichtungsmittel und zum Erhalt der Verarbeitbarkeit. Hiermit wird vermieden, daß der Füllstoff sich absetzt und daher vor der Verarbeitung erneut gleichmäßig verteilt werden muß. Das Antiabsetzmittel kann in Mengen von 0,1 bis 3 Gew.-% zugegeben werden, bezogen auf den Füllstoff. Beispiele für solche Mittel sind hochdispere Kieselsäure, Montmorillonit, Bentone oder Xonolith.

Die Beschichtungsmittel werden in an sich üblichen Verfahren durch Mischen der Komponenten, bevorzugt unter Anwendung hoher Scherkräfte hergestellt.

Sie können nach den üblichen Verfahren verarbeitet werden, wie z. B. durch Streichen, Spritzen, Rollen und Tauchen, insbesondere im Siebdruck-, Roller-coating-, Tampondruck- oder Aufschleuderverfahren sowie durch konventionelles Spritzen (mit Druckluft oder im sog. Airless-Verfahren) bzw. durch elektrostatisches Spritzen oder durch eine Kombination dieser Verfahren.

Das bevorzugte Vorhanggießverfahren, für das die erfindungsgemäßen Beschichtungsmittel besonders geeignet sind, kann wie folgt durchgeführt werden.

Man erzeugt einen dünnen, fallenden Vorhang des Beschichtungsmittels der mit oder ohne Druck aus einem Spalt fließt, wobei die Viskosität des Beschichtungsmittels bevorzugt zwischen 200 und 500 mPa s beträgt. Die Fallgeschwindigkeit des Vorhanges wird so gewählt, daß sie beim Auftreffen auf die Platte 60 bis 160, bevorzugt 70 bis 120 m/min beträgt. Die zu beschichtende Platte wird vorteilhaft vorerwärmt, z. B. auf 40 bis 100 °C. Die Platte wird mit einer Geschwindigkeit durch den fallenden Vorhang geführt, die etwa gleich und bevorzugt größer ist als die Fallgeschwindigkeit des Vorhanges. Nach der Beschichtung wird das Lösungsmittel langsam (Ablufttrocknung im Durchlauf- oder Standofen) entfernt, um eine Blasenbildung zu vermeiden, die Platte belichtet, entwickelt und danach die Schutzschicht thermisch gehärtet.

Die nachfolgenden Beispiele erläutern die Erfindung. Teile sind hierin Gew.-Teile.

### Beispiele 1 bis 4

### Herstellung der Bindemittelkomponente A

Allgemeine Vorschrift zur Herstellung von olefinisch ungesättigten Estern eines Epoxynovolakharzes (Epoxynovolakvinylester):

In einem Dreihalskolben mit Rührwerk, Rückflußkühler und Thermometer werden 1 Aquivalent eines Phenolnovolakepoxidharzes vorgelegt. Hierzu werden eine entsprechende Menge Lösungsmittel zugegeben, um eine 70 %ige Lösung herzustellen und unter Erwärmen und Rühren gelöst. Nach Zugabe von 1,02 Mol Acryl- bzw. Methacrylsäure und eines geeigneten Katalysators, wird auf 75 bis 85 °C erwärmt. Man läßt unter ständiger Kontrolle von Epoxidzahl und Säurezahl reagieren, bis eine Säurezahl von < 5 und eine Epoxidzahl 0,5 % erreicht ist. Anschließend wird die Lösung auf 70 % Feststoffgehalt eingestellt.

Die Ergebnisse finden sich in der folgenden Tabelle I.

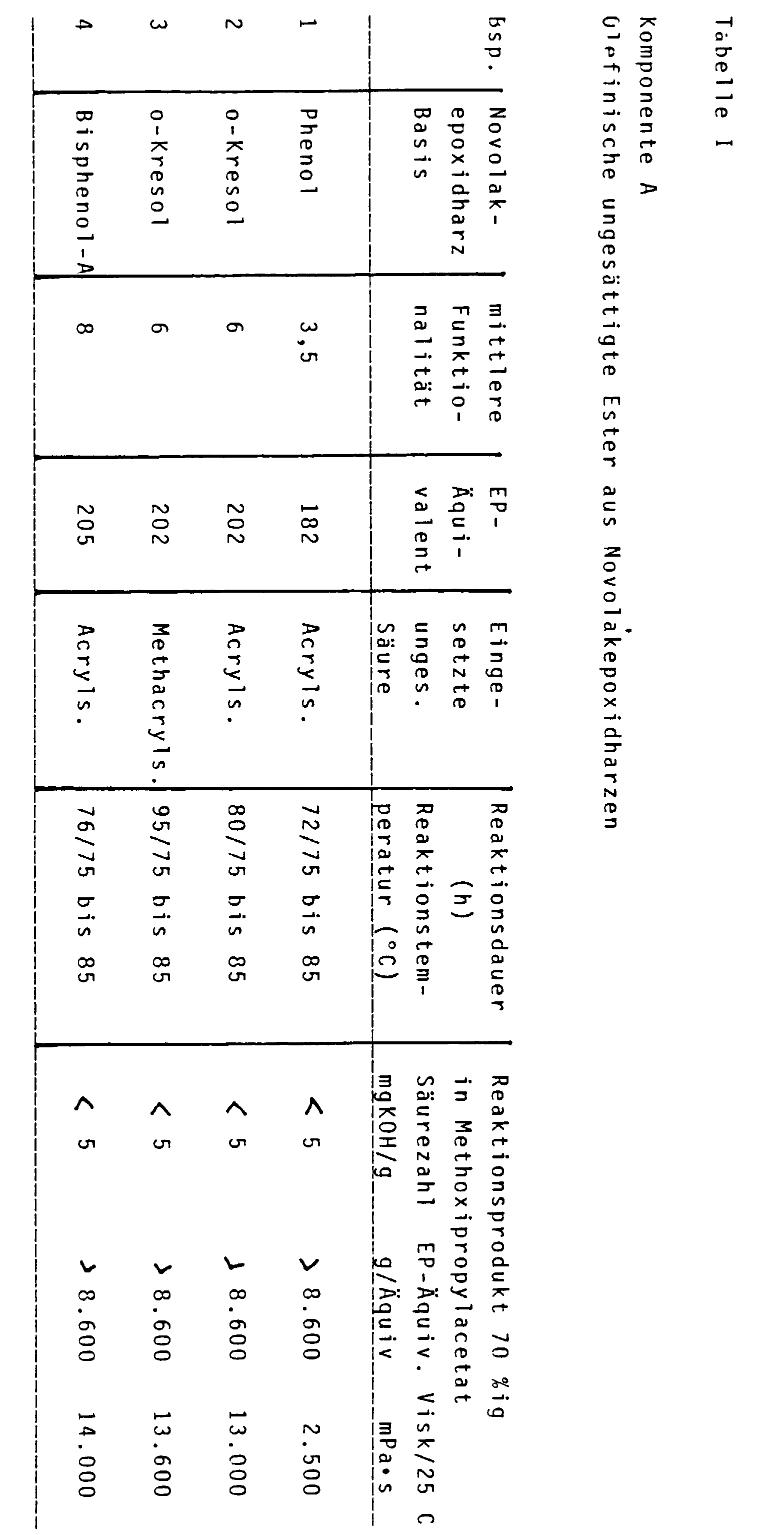

### Beispiele 5 bis 7

### Herstellung der Bindemittelkomponente B (entspricht EP-B 0 194 360)

### Herstellung von hydroxylgruppenhaltigen Epoxidharzen

### Beispiel 5

In einem Dreihalskolben mit Rührwerk, Rückflußkühler und Thermometer werden 1 Mol (= 619 g) eines Phenol-Novolak-Epoxidharzes mit einer durchschnittlichen Funktionalität von 3,5 vorgelegt. Das Harz wird mit ca. 200 g Xylol verdünnt und auf 80 °C erhitzt. Innerhalb von etwa 30 min werden 1,2 Mol Milchsäure 90 %ig zugetropft und die Mischung 2 h bei 80 °C gerührt. Die Säurezahl soll dann < 0,5 mgKOH/g betragen. Danach wird Xylol und Wasser abdestilliert und mit Methoxipropylacetat auf 70 % Festkörper verdünnt.

| | |
|---|---|
| Festkörper : | 70 % |
| EP-Äquivalent : | 452 g |
| OH-Äquivalent : | 432 g |

### Beispiel 6

Beispiel 5 wurde wiederholt und unter Verwendung eines o-Kresol-Novolak-Epoxidharzes mit einer Funktionalität von 6,5. Das Molverhältnis o-Kresol-Novolak-Epoxidharz zu Milchsäure lag bei 1 : 1,63.

| | |
|---|---|
| Festkörper : | 70 % |
| EP-Äquivalent : | 430 g |
| OH-Äquivalent : | 635 g |

### Beispiel 7

Beispiel 5 wurde wiederholt und unter Verwendung eines Bisphenol-A-Novolak-Epoxidharzes mit einer Funktionalität von 8. Das Molverhältnis Bisphenol-A-Novolak-Epoxidharz zu Milchsäure lag bei 1 : 1,33.

| | |
|---|---|
| Festkörper : | 70 % |
| EP-Aquivalent : | 387 g |
| OH-Äquivalent : | 950 g |

### Beispiel 8

Umsetzung eines Polyisocyanates mit hydroxylgruppenhaltigen, ungesättigten Verbindungen.

In einem Dreihalskolben mit Rührwerk, Rückflußkühler und Thermometer werden 1 Mol (= 174 g) Toluylen- (2.4 und 2.6) diisocyanat-Isomerengemisch (Desmodur T 80®) vorgelegt. Nach dem Verdünnen mit 130 g Methoxipropylacetat werden innerhalb von 30 min 1 Mol 2-Hydroxiethylacrylat beginnend bei Raumtemperatur zugegeben. Bedingt durch die exotherme Reaktion erwärmt sich diese Mischung auf ca. 80 °C. Man läßt 60 min bei dieser Temperatur nachreagieren. Am Ende der Reaktion versetzt man die 70 %ige Reaktionslösung mit 500 ppm eines Stabilisators (z. B. Hydrochinon).

| | |
|---|---|
| Festkörper : | 70 % |
| NCO-Äquivalent : | 420 g |

### Beispiele 9 bis 11

Umsetzung von hydroxylgruppenhaltigen Epoxidharzen gemäß Beispiel 5 bis 7 mit isocyanatgruppenhaltigen ungesättigten Verbindungen entsprechend Beispiel 8. Die Umsetzung erfolgte jeweils im OH/NCO-Verhältnis 1 : 0,8 bei 70 °C. Der Abbau des Isocyanats wurde mittels IR-Spektroskopie verfolgt. Die Umsetzung war im allgemeinen nach 15 h Reaktion bei 70 °C abgeschlossen.

### Beispiel 9

432 g (= 1 OH Äquivalent) hydroxylgruppenhaltiges Epoxidharz aus Beispiel 5 wurden in einen Dreihalskolben mit Rührwerk, Thermometer und Rückflußkühler vorgelegt und auf 70 °C erhitzt. 336 g Monoisocyanat = (0,8 NCO-Äquivalent) aus Beispiel 8 wurden innerhalb von 2 h bei 70 °C zugetropft. Nach 15 h Reaktion war Isocyanat nicht mehr nachweisbar.

| | |
|---|---|
| Viskosität 25 °C : | 42.500 mPa s |
| Festkörper : | 70 % |

### Beispiel 10

635 g (= 1 OH Äquivalent) hydroxylgruppenhaltiges Epoxidharz aus Beispiel 6 wurden in einen Dreihalskolben mit Rührwerk, Thermometer und Rückflußkühler vorgelegt und auf 70 °C erhitzt. 336 g Monoisocyanat (0,8 NCO-Äquivalent) aus Beispiel 8 wurden innerhalb von 2 h bei 70 °C zugetropft. Nach 15 h Reaktion war Isocyanat nicht mehr nachweisbar.

| | |
|---|---|
| Viskosität 25 °C : | 62.100 mPa s |
| Festkörper : | 70 % |

### Beispiel 11

950 g (= 1 OH Aquivalent) hydroxylgruppenhaltiges Epoxidharz aus Beispiel 7 wurden in einen Dreihalskolben mit Rührwerk, Thermometer und Rückflußkühler vorgelegt und auf 70 °C erhitzt. 336 g Monoisocyanat = (0,8 NCO-Äquivalent) aus Beispiel 8 wurden innerhalb von 2 h bei 70 °C zugetropft. Nach 15 h Reaktion war Isocyanat nicht mehr nachweisbar.

| | |
|---|---|
| Viskosität 25 °C : | 130.000 mPa s |
| Festkörper : | 70 % |

### Beispiele 12 bis 17

Durch 30 minütiges Vermischen in einem Planetenmischer wurden Mischungen (A) entsprechend der in Tabelle II aufgeführten Zusammensetzungen hergestellt. Vor Gebrauch wurden diese Mischungen mit einer Photoinitiatorpaste (B) der folgenden Zusammensetzung im Gewichtsverhältnis von 6 : 1 vermischt:

| Photoinitiatorpaste | |
|---|---|
| Polyvinylbutyralharz | 4 Teile |
| Benzildimethylketal | 17,55 Teile |
| Benzophenon | 2,45 Teile |
| Methoxypropylacetat (PMA) | 76,00 Teile |

Mit den so hergestellten Beschichtungsmitteln wurden Leiterplatten auf Phenolharzbasis nach dem Vorhanggießverfahren beschichtet. Es wurden einwandfrei beschichtete, blasenfreie Platten mit guter Kantendeckung erhalten, die in an sich üblicher Weise durch eine Schablone abgedeckt belichtet, danach entwickelt, thermisch gehärtet und mit üblichen Prüfungsverfahren getestet und beurteilt wurden.

Die erhaltenen Ergebnisse sind in Tabelle III aufgeführt. Die darin enthaltene Bewertung ist wie folgt zu verstehen:

| | |
|---|---|
| ++ | sehr gut |
| + | gut |
| +- | befriedigend |
| - | schlecht |
| -- | sehr schlecht |

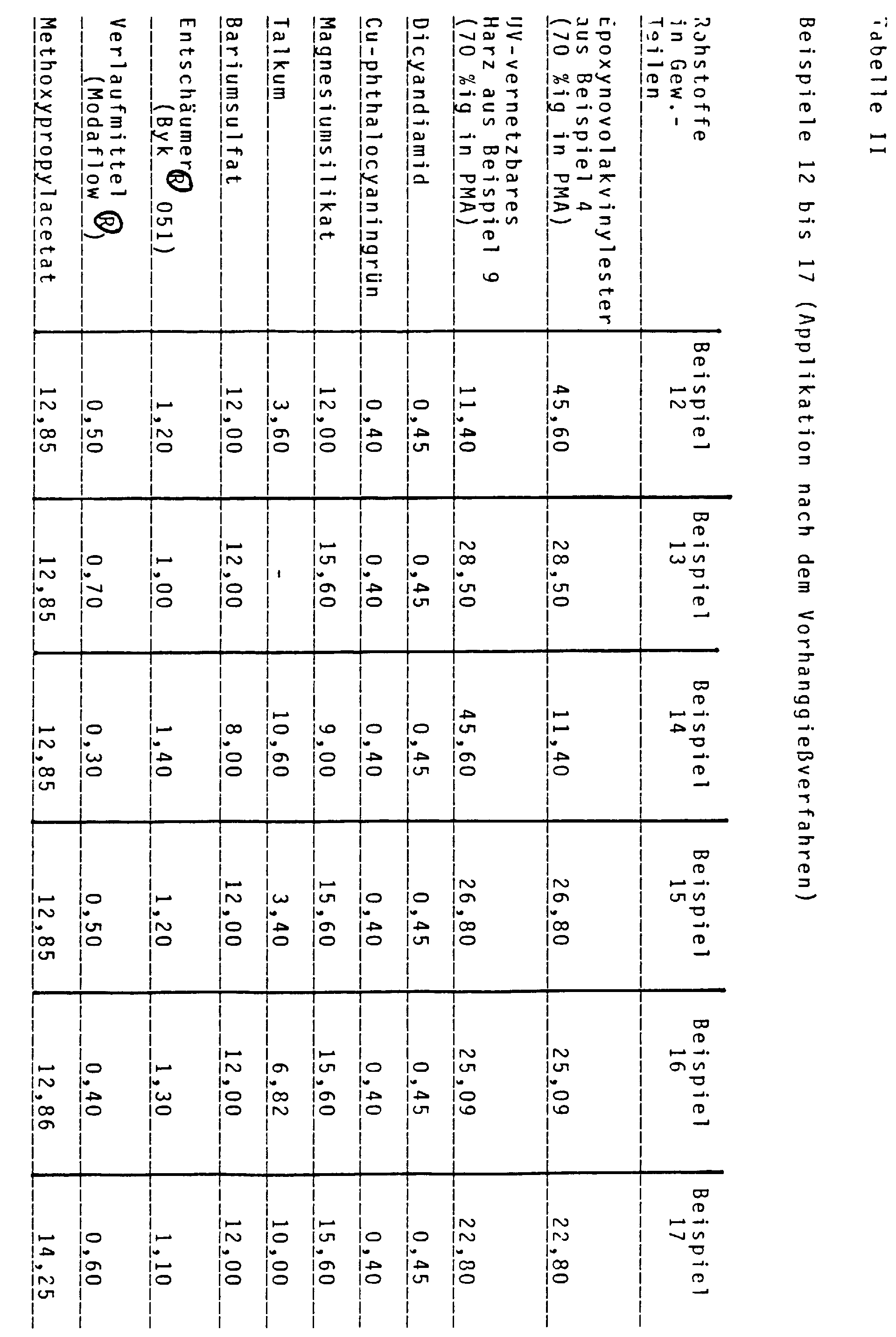

### Beispiel 18

Analog zu Beispiel 1 der EP-B 0 075 537 wurde ein Beschichtungsmittel hergestellt, wobei als Bindemittel die Bindemittelkomponenten aus den Beispielen 4 und 9 der vorliegenden Anmeldung (zu gleichen Teilen) eingesetzt wurden.

Das so hergestellte Beschichtungsmittel hatte eine Viskosität von 360 ±20 mPa·s bei 24 °C und einen Festkörpergehalt von 39 ± 2 Gew.-%.

Bei der Beschichtung nach dem Vorhanggießverfahren erhielt man keine verbesserte Kantendeckung (fehlerhafte Beschichtung z. B. viele pin-holes) der Leiter, sehr schlechte Haftung und dadurch bedingte schlechte Lötbadbeständigkeit.

Eine weitere Beurteilung ist in Tabelle III gegeben.

### Beispiel 19

Analog zu den Beispielen 12 bis 17 wurde ein Beschichtungsmittel der folgenden Zusammensetzung hergestellt, nach dem Siebdruckverfahren auf eine Leiterplatte aufgetragen und entsprechend weiter behandelt und getestet:

| Bindemittelkomponente: | |
|---|---|
| | Gew.-% |
| Epoxynovolak aus Beispiel 4 (70 %ig in PMA) | 31,50 |
| | |

| | Gew.-% |
|---|---|
| UV-vernetzbares Harz aus Beispiel 9 (70 %ig in PMA) | 39,00 |
| Dicyandiamid | 0,60 |
| Cu-phthalocyaningrün | 0,35 |
| Talkum | 26,95 |
| Entschäumer (Byk® 051) | 0,20 |
| Verlaufmittel (Modaflow®) | 0,90 |
| Methoxypropylacetat | 0,50 |
| | |

| Photoinitiatorpaste: | |
|---|---|
| Polyvinylbutyralharz | 6,60 |
| Benzildimethylketal | 25,20 |
| Benzophenon | 1,95 |
| Methoxypropanol | 66,25 |

Mischungsverhältnis der Bindemittelkomponente : Photoinitiatorpaste = 6 : 1.

Die erhaltenen Ergebnisse finden sich ebenfalls in Tabelle III.

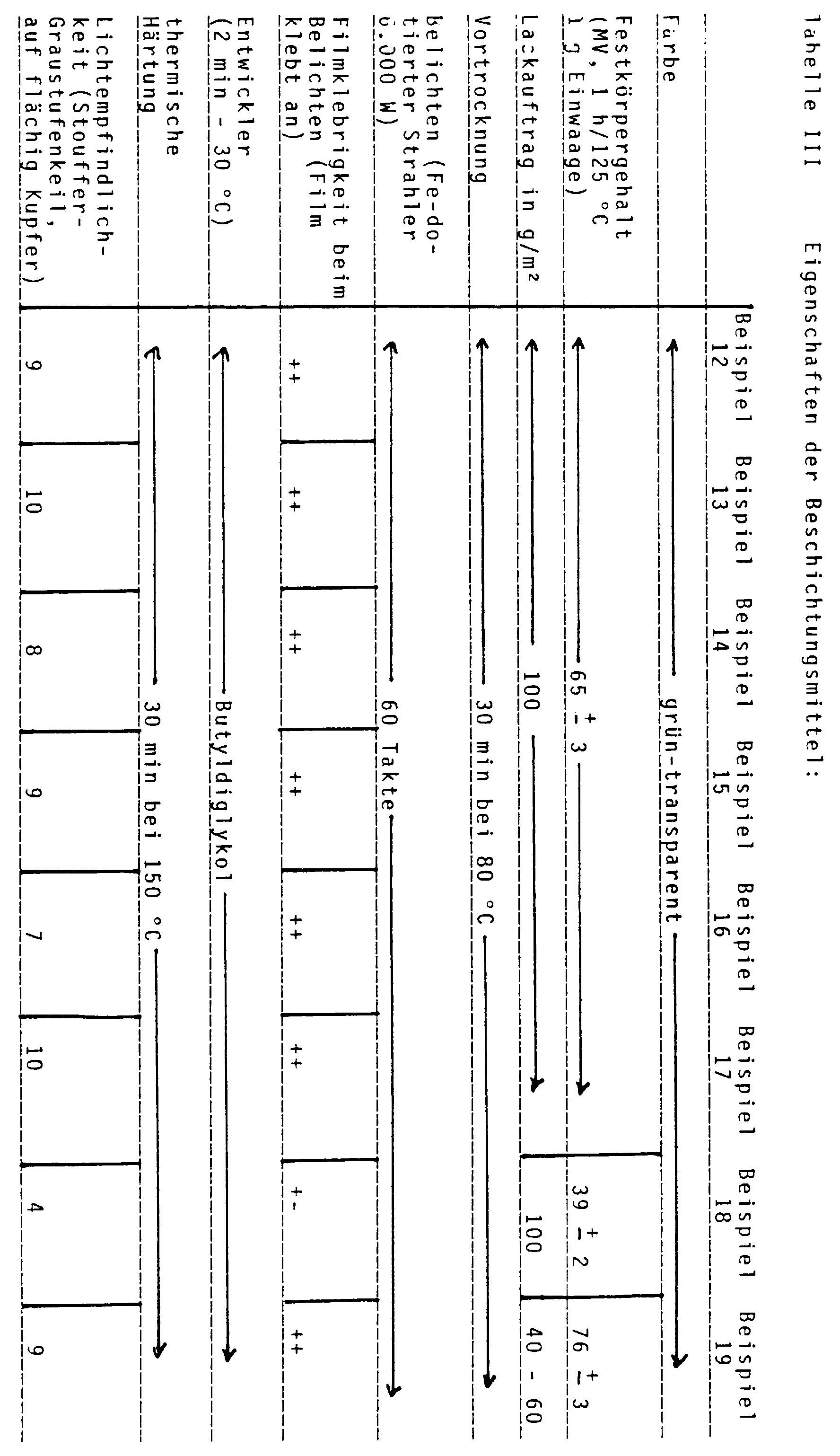

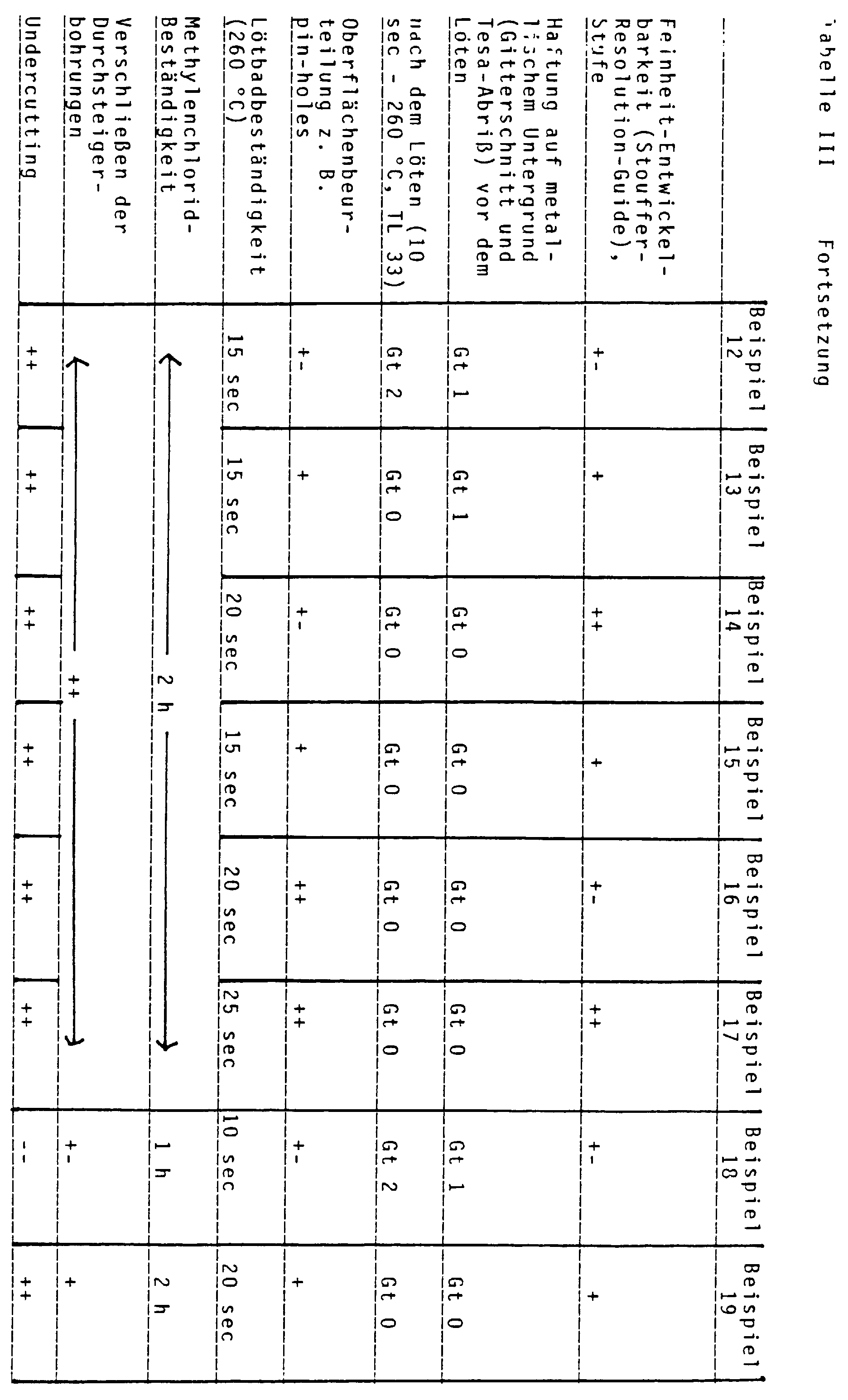

## Patentansprüche

1. Durch Strahlung vernetzbare Beschichtungsmittel, **dadurch gekennzeichnet**, daß sie neben einem oder mehreren latenten Härtern, Photoinitiator(en) und ggf. weiteren Füll-, Zusatz- und Hilfsstoffen sowie Lösemitteln folgende Bindemittelkomponenten enthält:
a. einen olefinisch ungesättigten Ester eines Epoxynovolakharzes und
b. ein Bindemittel, das erhalten wird durch Umsetzung einer Epoxidverbindung mit mehr als 1 Epoxidgruppe pro Molekül, mit einer oder mehreren Carbonsäuren im molaren Verhältnis der Epoxidgruppen zu den Carboxylgruppen von 1 : 0,5 bis 0,9 und anschließender Umsetzung des Reaktionsproduktes mit einer oder mehreren ungesättigten Isocyanatocarbamatestern, die durch Umsetzung von Verbindungen mit mindestens zwei Isocyanatgruppen mit hydroxylgruppenhaltigen Acryl-, Methacryl- oder Cyanacrylsäureestern hergestellt werden.

2. Beschichtungsmittel nach Anspruch 1, **dadurch gekennzeichnet**, daß es die beiden Bindemittelkomponenten a und b im Verhältnis 80 : 20 bis 20 : 80 enthält.

3. Beschichtungsmittel nach den Ansprüchen 1 und 2, **dadurch gekennzeichnet**, daß die Bindemittelkomponente b als Epoxidharzkomponente einen Novolak enthält, dessen phenolische Hydroxylgruppen mit Glycidylgruppen veräthert sind.

4. Beschichtungsmittel nach den Ansprüchen 1 bis 3, **dadurch gekennzeichnet**, daß die Epoxidharzkomponente als Bindemittelkomponente b Zusätze von mono- oder bifunktionellen Epoxidverbindungen enthält.

5. Beschichtungsmittel nach den Ansprüchen 1 bis 4, **dadurch gekennzeichnet**, daß die Bindemittelkomponente b ein Durchschnittsmolekulargewicht von 500 bis 10.000 besitzt.

6. Beschichtungsmittel nach den Ansprüchen 1 bis 5, **dadurch gekennzeichnet**, daß die carbonsäuremodifizierten Epoxidharze und die Isocyanatocarbamatester der Bindemittelkomponente b im molaren Verhältnis der Hydroxylgruppen zu den Isocyanatgruppen von 1 : 0,8 bis 1 : 1 miteinander umgesetzt werden.

7. Beschichtungsmittel nach den Ansprüchen 1 bis 6, **dadurch gekennzeichnet**, daß sie als latente Härter für die Vernetzung und die thermische Härtung Verbindungen vom Typ des Michler's Ketons enthalten.

8. Beschichtungsmittel nach den Ansprüchen 1 bis 7, **dadurch gekennzeichnet**, daß sie einen Füllstoffgehalt von 80 bis 120 Gew.-%, bezogen auf das Bindemittelgemisch, enthält.

9. Beschichtungsmittel nach den Ansprüchen 1 bis 7, **dadurch gekennzeichnet**, daß sie 25 bis 40 Gew.-% Lösemittel, bezogen auf das gesamte Beschichtungsmittel, enthält.

10. Verwendung der Beschichtungsmittel nach den Ansprüchen 1 bis 9 zur Herstellung von Beschichtungen für die Elektronik und Elektrotechnik.

11. Verwendung der Beschichtungsmittel nach den Ansprüchen 1 bis 9 als Lötstopplack.

12. Verwendung der Beschichtungsmittel nach den Ansprüchen 1 bis 9 zur Herstellung von Schutzmasken nach dem Vorhanggießverfahren.

13. Verwendung der Beschichtungsmittel nach den Ansprüchen 1 bis 9 zur Herstellung von Lötstopmasken im Siebdruck-, Roller-coating-Verfahren, Tampondruck oder Aufschleuderverfahren.

14. Verwendung der Beschichtungsmittel nach den Ansprüchen 1 bis 9 zur Herstellung von Schutzmasken durch konventionelles Spritzen (Druckluft oder Airless) bzw. elektrostatisches Spritzen oder einer Kombination dieser Verfahren.

## Claims

1. Coating agents cross-linkable by radiation, characterized in that in addition to one or more latent hardeners, photo-initiator(s) and optionally further fillers, additives and adjuvants and solvents they contains [*sic*] the following binder components:
a) an olefin-unsaturated ester of an epoxynovolak resin, and
b) a binder which is obtained by reacting an epoxy compound with more than one epoxy group *per* molecule, with one or more carboxylic acids in the molar ratio of the epoxy groups to the carboxyl groups of 1 : 0.5 to 0.9 and subsequent reaction of the reaction product with one or more unsaturated isocyanate carbamate esters, which are prepared by reacting compounds with at least two isocyanate groups with acrylic, methacrylic or cyanacrylic acid esters containing hydroxy groups.

2. A coating agent according to Claim 1, characterized in that it contains the two binder components a and b in the ratio of from 80 : 20 to 20 : 80.

3. A coating agent according to Claims 1 and 2, characterized in that the binder component **b** contains as an epoxy resin component a novolak, the phenol hydroxy groups of which are etherified with glycidyl groups.

4. A coating agent according to Claims 1 to 3, characterized in that the epoxy resin component contains additions of mono- or bifunctional epoxy compounds as the binder component **b**.

5. A coating agent according to Claims 1 to 4, characterized in that the binder component **b** has an average molecular weight of from 500 to 10,000.

6. A coating agent according to Claims 1 to 5, characterized in that the epoxy resins modified with carboxylic acid and the isocyanate carbamate esters of the binder component **b** are reacted together in the molar ratio of the hydroxy groups to the isocyanate groups of from 1 : 0.8 to 1 : 1.

7. Coating agents according to Claims 1 to 6, characterized in that they contain compounds of the type of Michler's ketone as latent hardeners for cross-linking and thermal hardening.

8. Coating agents according to Claims 1 to 7, characterized in that they contains [*sic*] a filler content of from 80 to 120% by weight relative to the binder mixture.

9. Coating agents according to Claims 1 to 7, characterized in that they contains [*sic*] from 25 to 40% of solvents relative to the total coating agent.

10. Use of the coating agents according to Claims 1 to 9 for the preparation of coatings for electronics and electrical engineering.

11. Use of the coating agents according to Claims 1 to 9 as solder resist.

12. Use of the coating agents according to Claims 1 to 9 for the preparation of protective masks in accordance with the curtain-casting process.

13. Use of the coating agents according to Claims 1 to 9 for the preparation of solder-resist masks in the screen-printing process, roller-coating process, dabbing printing or spin-on deposition.

14. Use of the coating agents according to Claims 1 to 9 for the preparation of protective masks by conventional spraying (compressed air or airless) or electrostatic spraying or a combination of these processes.

## Revendications

1. Revêtements réticulables sous rayonnement, caractérisés en ce qu'il contiennent, outre un ou plusieurs durcisseurs latents, photo-initiateur (s) et, le cas échéant d'autres matières de charge, additifs et adjuvants ainsi que des solvants, les composants de liant suivants :
a. un ester oléfiniquement insaturé d'une résine époxy-novolaque et
b. un liant qui est obtenu par réaction d'un composé époxydique possédant plus de 1 groupe époxy par molécule, avec un ou plusieurs acides carboxyliques dans le rapport molaire des groupes époxy aux groupes carboxyles de 1:0,5 à 0,9 et réaction subséquente du produit de réaction avec un ou plusieurs esters isocyanatocarbamiques insaturés qui sont préparés par réaction de composés comportant au moins deux groupes isocyanates avec des esters acryliques, méthacryliques ou cyanoacryliques hydroxylés.

2. Revêtement selon la revendication 1, caractérisé en ce qu'il contient les deux composants de liant a et b dans un rapport de 80:20 à 20:80.

3. Revêtement selon les revendications 1 et 2, caractérisé en ce que le composant de liant b contient, en tant que résine époxydique, une novolaque dont les groupes hydroxyles phénoliques sont éthérifiés avec des groupes glycidyles.

4. Revêtement selon les revendications 1 à 3, caractérisé en ce que le composant résine époxydique contient, en tant que composant de liant b, des additions de composés époxydiques mono- ou difonctionnels.

5. Revêtement selon les revendications 1 à 4, caractérisé en ce que le composant de liant b possède un poids moléculaire moyen de 500 à 10.000.

6. Revêtement selon les revendications 1 à 5, caractérisé en ce que l'on fait réagir ensemble les résines époxydiques modifiées par des acides carboxyliques et les esters isocyanatocarbamiques du composant de liant b dans le rapport molaire des groupes hydroxyles aux groupes isocyanates de 1:0,8 à 1:1.

7. Revêtements selon les revendications 1 à 6, caractérisés en ce qu'ils contiennent comme durcisseurs latents pour la réticulation et le durcissement thermique des composés du type cétone de Michler.

8. Revêtement selon les revendications 1 à 7, caractérisé en ce qu'il possède une teneur en matières de charge de 80 à 120% en poids, rapportés au mélange de liants.

9. Revêtement selon les revendications 1 à 7, caractérisé en ce qu'il contient 25 à 40% en poids de solvant, rapportés au revêtement total.

10. Utilisation des revêtements selon les revendications 1 à 9 pour la préparation d'enduits pour l'électronique et l'électrotechnique.

11. Utilisation des revêtements selon les revendications 1 à 9 en tant que réserve de soudure.

12. Utilisation des revêtements selon les revendications 1 à 9 pour la confection de masques protecteurs selon le procédé de coulée au rideau.

13. Utilisation des revêtements selon les revendications 1 à 9 pour la confection de masques par sérigraphie, par le procédé d'enduction au rouleau, par impression au tampon ou par un procédé d'application par centrifugation.

14. Utilisation des revêtements selon les revendications 1 à 9 pour la confection de masques protecteurs par pistolage conventionnel (air comprimé ou airless), respectivement par pistolage électrostatique ou par une combinaison de ces procédés.
